# EUROPEAN PATENT APPLICATION

(11) **EP 2 339 763 A1**
(43) Date of publication of application: **29.06.2011**
(21) Application number: 09820357.3
(22) Date of filing: 23.06.2009
(51) Int. Cl.: H04B 17/00, G01R 19/165, H03F 1/52, H03F 3/24, H04B 1/04

(54) **CURRENT DETECTOR**

(30) Priority: 17.10.2008 JP 2008268900
(71) Applicant: Panasonic Corporation, Kadoma-shi Osaka 571-8501 (JP)
(72) Inventor: FUKASAWA, Tishinori c/o Panasonic Corporation IPROC, Chuo-ku, Osaka-shi, Osaka 540-6207 (JP)
(74) Representative: Grünecker, Kinkeldey, Stockmair & Schwanhäusser Anwaltssozietät
(86) International application number: PCT/JP2009/002880
(87) International publication number: WO 2010/044178

(57) **Abstract**

Provided is a current detector which can accurately determine whether or not a transmission current is abnormal in the TDMA system. The sampling is performed on two frames in a regular manner. It is determined that the transmission current (I) is abnormal when the transmission current (I) is detected in all of the 16 slots within the two frames. If it is determined that the transmission current (I) is normal when the transmission current (I) is not detected in anyone of slots. Further, the determination result is decided when the error determination results coincide for N consecutive times. This makes it possible to accurately determine the presence/absence of an abnormality of a transmitting current in the TDMA system.

## Description

### Technical Field

The present invention relates to a current detector suitable for use in mobile phones according to the TDMA (Time Division Multiple Access) system.

### Background Technique

The TDMA system is known as one of the radio communication systems used for digital mobile phones. According to the TDMA system, a plurality of mobile phones share the same frequency band by switching at every constant time period. For example, the frame length of the GSM (Global System for Mobile Communication) is 4.615 msec and each frame is formed by eight slots. Since a single slot is allocated to each user, a single GSM carrier wave can be shared by eight users at the maximum. A length of one slot becomes 576.923 µsec.

As an RF amplifier for amplifying TDMA radio signals, there has been proposed one which monitors the level of RF signals with a predetermined time interval (predetermined slot interval) and evaluates the levels (see a patent document 1, for example).

### Prior Art Document

### Patent Document

Patent Document 1 JP-A-7-058564

### Summary of the Invention

### Problems that the Invention is to Solve

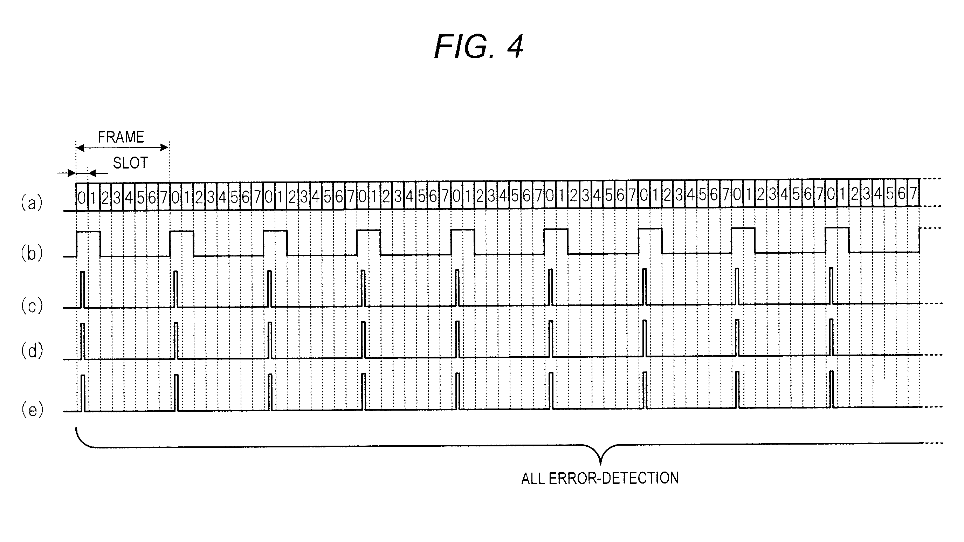

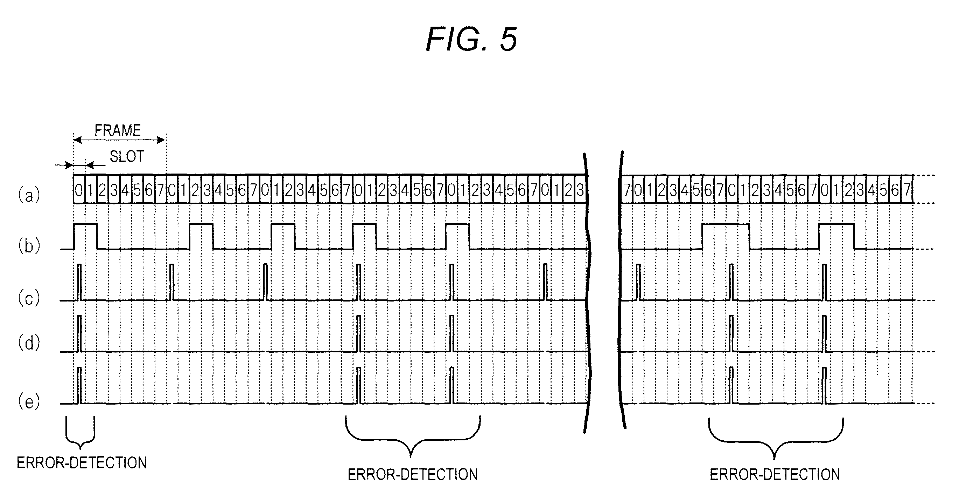

Concerning the transmission timing of the GSM of the related art, it is not sure as to which slot is transmitted at which timing. Thus, according to the periodical sampling detection of the related art, it may be determined that an abnormal current flows when the transmission current of a transmission power amplifier (equivalent to the RF amplifier) is detected. An example of such the determination will be explained with reference to operation waveforms shown in Figs. 4 and 5. In each of Figs. 4 and 5, (a) shows an example of the GSM transmission, (b) shows an example of two-slot transmission, (c) shows an example of a sampling period, (d) shows an example of error detection and (e) shows an example of the determination of the error detection.

Fig. 4 shows an example where the two-slots transmission is performed in a regular manner, in which it is determined to be error when the period of the two-slots transmission coincides with the sampling for detecting currents flowing into the transmission power amplifier. In this example, the error detection is performed at the every transmission. Fig. 5 shows an example where the two-slots transmission is performed in an irregular manner, in which it is determined to be error when the timing of transmission, not the two-slot transmission, coincides with the sampling timing. In this manner, despite that normal slot transmission is performed, it is determined to be error when the sampling timing coincides with the transmission timing.

This invention is made in view of the aforesaid circumstances and an object of the invention is to provide a current detector which can accurately determine whether or not a transmission current is abnormal in the TDMA system.

### Means for Solving the Problems

There is provided the current detector of the present invention, comprising:
a current detection section that detects a transmission current of a transmission power amplifier in each of a plurality of slots constituting a frame; and
a sampling section which samples the transmission current detected by the current detection section for at least two frames and determines whether or not the transmission current is abnormal according to levels of the transmission current within the at least two frames.

According to the above, the transmission current of the transmission power amplifier is detected in each of the plurality of slots constituting the frame. Further, the transmission current detected by the current detection section is sampled during at least two frames and determines whether or not the transmission current is abnormal according to levels of the transmission current within the at least two frames. Thus, the abnormality of the transmission current in the TDMA system can be determined accurately.

Also, the current detector further comprises a determination result decision section that decides determination results of the sampling section when determination results of the sampling section coincide for a predetermined number of consecutive times.

According to the above configuration, since the determination result is decided when the determination results coincide for the predetermined number of consecutive times, the determination can be decided more accurately as to whether or not the transmission current is abnormal. That is, the determination accuracy can be improved.

Also, a mobile phone includes the current detector.

According to the above configuration, since it becomes possible to accurately determine as to the abnormality of the transmission current of the mobile phone according to the TDMA system, the occurrence of a failure or a trouble due to the abnormality of the transmission current can be suppressed to the minimum degree by stopping the transmission at the time of the abnormality of the transmission current, for example.

### Effects of the Invention

According to the invention, the transmission current of the transmission power amplifier is detected at each of the plurality of slots constituting a frame. Further, the transmission current is sampled during at least two frames to determine whether or not the transmission current is abnormal according to levels of the transmission current within the at least two frames. Thus, the abnormality of the transmission current in the TDMA system can be determined accurately.

### Brief Description of the Drawings

[Fig. 1] A block diagram showing the schematic configuration of a current detector according to one embodiment of the invention and the transmission circuit of a mobile phone according to the GSM using the current detector.
[Fig. 2] A diagram for explaining the operation of the sampling section of the current detector shown in Fig. 1.
[Fig. 3] A diagram for explaining the operation of the sampling section of the current detector shown in Fig. 1.
[Fig. 4] A diagram for explaining the problem in the GSM of the related art.
[Fig. 5] A diagram for explaining the problem in the GSM of the related art.

### Mode for Carrying Out the Invention

A suitable exemplary embodiment for carrying out the invention will be explained in detail with reference to drawings.

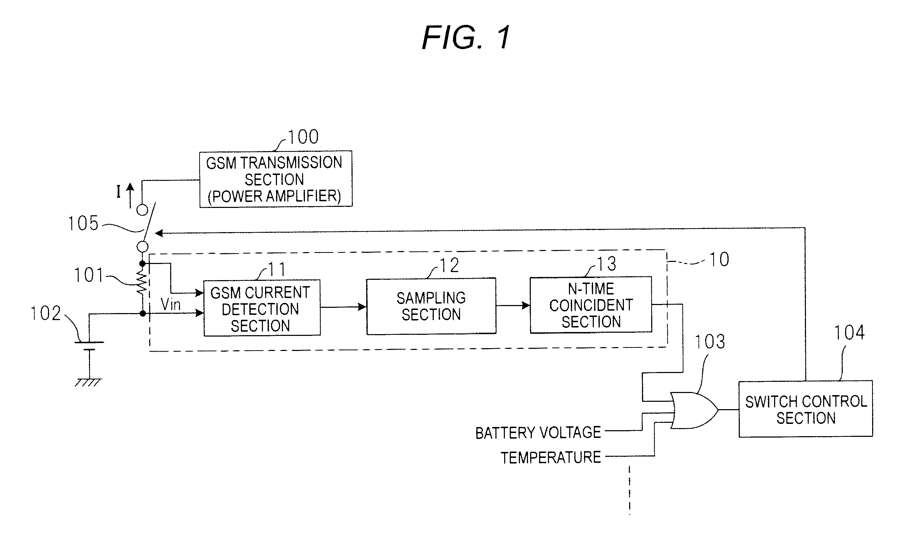

Fig. 1 is a block diagram showing the schematic configuration of a current detector according to one embodiment of the invention and the transmission circuit of a mobile phone according to the GSM using the current detector. In Fig. 1, the current detector 10 according to the embodiment includes a GSM current detection section 11, a sampling section 12 and an N-time coincident section 13. The GSM current detection section 11 corresponds to a current detection section and the sampling section 12 corresponds to a sampling section.

The GSM current detection section 11 detects a transmission current I flowing into a GSM transmission section 100 having a transmission power amplifier at each of eight slots constituting a frame, and outputs an output of Hi level (high level) while the transmission current I is detected and outputs an output of Lo level (low level) while the transmission current is not detected. That is, the GSM current detection section 11 sets the output level to High level when the current value is a predetermined value or more, whilst sets the output level to Low level when the current value is the predetermined value or less. A voltage Vin which is obtained by converting the transmission current I into a voltage by a resistor 101 is input to the GSM current detection section 11. The GSM current detection section 11 detects the transmission current I flowing into the GSM transmission section 100 based on the voltage Vin. Of course, the resistor 101 is inserted between the GSM transmission section 100 and a battery 101.

The sampling section 12 performs the sampling of two frames in a regular manner to thereby determine whether or not the transmission current is abnormal in accordance with the level of the transmission current I in the two frames. The sampling frequency used in the sampling section 12 is 1.733 kHz or more so that the transmission current I in each of 16 slots within the two frames can be detected. In other words, since one slot time is defined as 576.923 µsec in the case of the GSM, the sampling frequency is determined as an inverse of the frequency. Since the time period of the single frame is defined as 4.615 msec, the time period of the two frames is the twice of the single frame time, that is, 9.23 msec.

The sampling section 12 determines that the transmission current I is abnormal when the transmission current I is detected in all of the 16 slots within the two frames, whilst determines that the transmission current I is normal when the transmission current I is not detected in anyone of slots. That is, it is determined whether or not the transmission current I is abnormal in accordance with the levels of the transmission current I in the two frames. When the level of the transmission current I is continuously High level, it is determined that the transmission current I flows during the entire period of the two frames. Thus, since this transmission mode can be regarded as unmeaningful or insignificant, the transmission current I can be determined as abnormal. In contrast, when the level of the transmission current I is not continuously High level, it is determined that the transmission current I does not flow in anyone of the 16 slots within the two frames. Thus, since this transmission mode can be regarded as meaningful or significant, the transmission current I can be determined as normal.

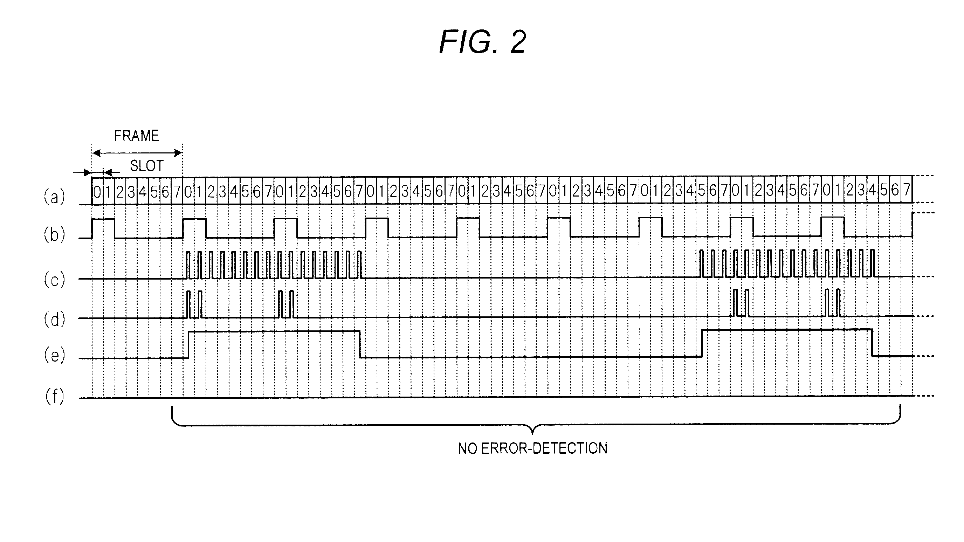

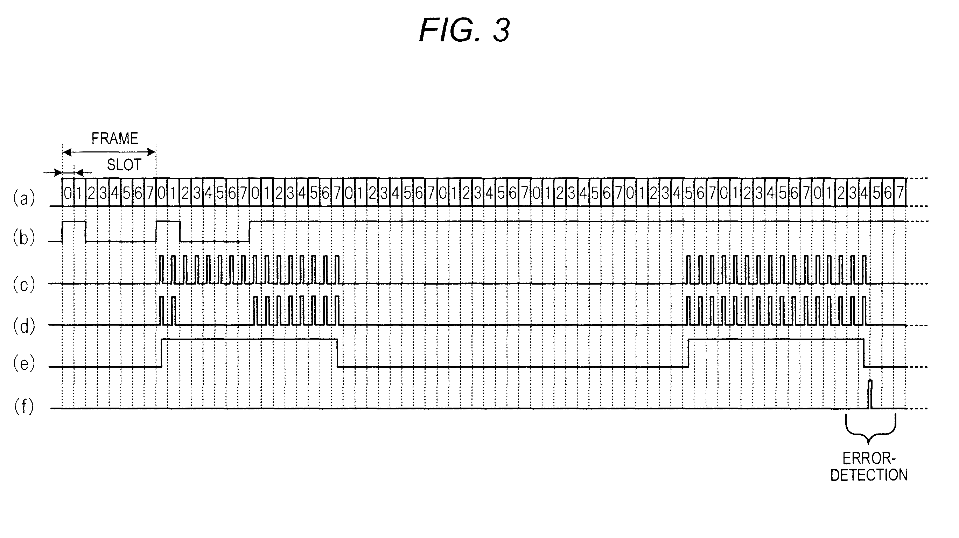

The operation of the sampling section 12 will be explained with reference to operation waveforms shown in Figs. 2 and 3. In each of Figs. 2 and 3, (a) shows an example of the GSM transmission, (b) shows an example of the two-slots transmission, (c) shows an example of the sampling period, (d) shows an example of the error detection, (e) shows an example of a sampling group period and (f) shows an example of the determination of the error detection. Fig. 2 shows an example where the two-slots transmission is performed in the regular manner. The sampling operation for the two frames is performed regularly and the transmission current I is detected in the 4 slots within the two frames. That is, the errors are detected four times. However, in this case, although the transmission current I is detected in the four slots within the two frames, since the current detection is not performed in all of the slots within the two frames, it is not determined that the error is detected. On the other hand, Fig. 3 shows an example where the two-slots transmission is performed regularly and then the transmission state is changed into a continuous transmission state halfway. In Fig.3, although the transmission current I is detected in the 10 slots within the preceding two frames subjected to the sampling, since the current detection is not performed in all of the slots within the two frames, it is not determined that the error is detected. However, in the next two frames subjected to the sampling, since the transmission current I is detected in all of the slots within the two frames, it is determined that the error is detected. In this manner, it is determined that the error is detected when the transmission current I is detected in all of the slots within the two frames.

However, since there is a case that the transmission mode is regarded as meaningful or significant even when the transmission current I is detected in all of the slots within the two frames, the determination result is decided when the error determination results coincide for N consecutive times (predetermined number of times). As a result, the error determination accuracy can be improved. This decision is performed by the N-time coincident section 13. That is, the N-time coincident section 13 decides that the transmission current I is abnormal when the error determination results coincide for N consecutive times and changes the output thereof into the High level at this timing.

When the output of the N-time coincident section 13 becomes the High level by determining that the transmission current I is abnormal, the output of an OR gate 103 becomes the High level. When the output of the N-time coincident section 13 becomes the High level, a switch control section 104 changes a switch 105 disposed between the resistor 101 and the GSM transmission section 100 into an opened state to thereby change the GSM transmission section 100 in an operation stop state. The OR gate 103 has a plurality of input terminals to which battery voltage information, temperature information etc. as well as the decided information from the N-time coincident section 13 are inputted. The battery voltage information is input into the OR gate 103 as a High level signal when the voltage of the battery 102 reduces to a predetermined level or less or when a power supply adaptor (not shown) is detached. The temperature information is input into the OR gate 103 as a High level signal when the temperature of the GSM transmission section 100 increases to a predetermined level or more. When the high level signal is input into the OR gate 103, the output of the OR gate 103 becomes the Hi level.

According to the current detector 10 of the embodiment, the sampling is performed regularly in the two frames, and the transmission current I is determined as abnormal when the transmission current I is detected in all of the 16 slots within the two frames, whilst the transmission current I is determined as normal when the transmission current I is not detected in anyone of the slots. This makes it possible to accurately determine the presence/absence of an abnormality of a transmitting current in the TDMA system.

Further, since the determination result is decided when the error determination results coincide for N consecutive times, the accuracy of the determination result can be improved. When this current detector is employed in the mobile phone according to the GSM, it becomes possible to accurately determine the abnormality of the transmission current in the mobile phone. Thus, the occurrence of a failure or a trouble due to the abnormality of the transmission current can be suppressed to the minimum degree by stopping the transmission at the time of the abnormality of the transmission current, for example.

Although the explanation is made as to the exemplary embodiment where the single frame is formed by eight slots according to the GSM, the invention can be implemented so long as the TDMA system is employed even if the number of the slots constituting the single frame is not "8".

Although the invention is explained in detail with reference to the particular exemplary embodiment, it will be apparent for those skilled in the art that various changes and modifications are possible without departing from the spirit and range of the invention.
This invention is based on Japanese Patent Application (Japanese Patent Application No. 2008-268900) filed on October 17, 2008, the contents of which are incorporated herein by reference.

### Industrial Applicability

The invention has effects that the determination can be performed accurately as to whether or not the transmission current is abnormal, and is applicable to mobile phones according to the TDMA system, for example.

### Explanation of Signs

- 10: current detector
- 11: GSM current detection section
- 12: sampling section
- 13: N-time coincident section
- 100: GSM transmission section
- 101: resistor
- 102: battery
- 103: OR gate
- 104: switch control section
- 105: switch

## Claims

1. A current detector, comprising:
a current detection section that detects a transmission current of a transmission power amplifier in each of a plurality of slots constituting a frame; and
a sampling section which samples the transmission current detected by the current detection section for at least two frames and determines whether or not the transmission current is abnormal according to levels of the transmission current within the at least two frames.

2. The current detector according to claim 1, further comprising:
a determination result decision section that decides determination results of the sampling section when determination results of the sampling section coincide for a predetermined number of consecutive times.

3. A mobile phone including the current detector according to claim 1 or 2.
